Europäisches Patentamt

European Patent Office

Office européen des brevets

(19)

(11) Veröffentlichungsnummer: **0 377 872**

**A2**

# (12) EUROPÄISCHE PATENTANMELDUNG

(21) Anmeldenummer: **89123576.4**

(22) Anmeldetag: **20.12.89**

(51) Int. Cl.⁵: **H05K 3/34**

(30) Priorität: **09.01.89 DE 3900420**

(43) Veröffentlichungstag der Anmeldung:
**18.07.90 Patentblatt 90/29**

(84) Benannte Vertragsstaaten:
**AT BE CH DE ES FR GB GR IT LI NL SE**

(71) Anmelder: **Siemens Aktiengesellschaft**
**Wittelsbacherplatz 2**
**D-8000 München 2(DE)**

(72) Erfinder: **Schmidt, Hans-Friedrich, Dr.-Ing.**
**Graf Trattenbachweg 3**
**D-8196 Eurasburg(DE)**
Erfinder: **Hadwiger, Helmut, Dipl.-Ing.**
**Friedrich Herschelstrasse 5/27**
**D-8000 München 80(DE)**
Erfinder: **Prochazka, Milan, Dipl.-Ing.**
**Beblostrasse 15**
**D-8000 München 80(DE)**
Erfinder: **Roelants, Eddy, Dr.**
**P. Ascanusstrasse 31**
**B-1700 Asse(BE)**

(54) Verfahren zum Aufbringen einer Lötstoppabdeckung auf Leiterplatten.

(57) Auf die Leiterplatte werden nacheinander ganzflächig ein lichtempfindlicher, negativer Lötstopplack (5), eine Metallschicht (6) und eine Ätzresistschicht (7) aufgebracht, worauf die Ätzresistschicht (7) in den unmittelbar an Durchkontaktierungen (3) und/oder Lötpads (4) angrenzenden Bereichen mittels elektromagnetischer Strahlung (S), vorzugsweise mittels Laserstrahlung, wieder entfernt wird. Nach dem Entfernen der dadurch freigelegten Bereiche der Metallschicht (6) wird die Ätzresistschicht (7) mit Ausnahme der den Durchkontaktierungen (3) und/oder Lötpads (4) zugeordneten Bereiche anodisch kontaktiert und elektrolytisch abgetragen, so daß nach dem Abätzen der hierdurch freigelegten Metallschicht (6) die verbleibenden Bereiche der Metallschicht (6) und der Ätzresistschicht (7) eine metallische Fotomaske bilden. Nach dem Belichten des Lötstopplacks (5) brauchen dann nur noch diese Fotomaske und die darunterliegenden, unbelichteten Bereiche des Lötstopplacks (5) entfernt werden. Das erfindungsgemäße Verfahren ist insbesondere für das Aufbringen einer Lötstoppabdeckung auf dreidimensionale Leiterplatten geeignet, da hier herkömmliche Maskentechniken zur Schutzwirkung des Lötstopplackes nicht anwendbar sind.

FIG 5

## Verfahren zum Aufbringen einer Lötstoppabdeckung auf Leiterplatten

Die Erfindung betrifft ein Verfahren zum Aufbringen einer Lötstoppabdeckung auf das Leiterbild von Leiterplatten, insbesondere von dreidimensionalen Leiterplatten, unter Freilassung von Durchkontaktierungen und/oder Lötpads.

Bei der Herstellung von Leiterplatten soll nach der Strukturierung des Leiterbildes auf diejenigen Bereiche des Leiterbildes die keine Lötverbindung eingehen sollen eine Lötstoppabdeckung aufgebracht werden. Diese Lötstoppabdeckung läßt nur Durchkontaktierungen und/oder Lötpads frei, so daß dort dann durch Heißverzinnen eine Zinnschicht oder auch eine Zinn-Blei-Schicht aufgebracht werden kann. Das Aufbringen der Lötstoppabdeckung kann dabei durch selektives Auftragen eines Lötstopplackes auf die zu schützenden Bereiche oder durch ganzflächiges Auftragen eines lichtempfindlichen Lötstopplackes mit anschließender Fotostrukturierung vorgenommen werden. Das selektive Auftragen ist dabei mit einem zu großen Aufwand verbunden, während die Fotostrukturierung insbesondere bei dreidimensionalen Leiterplatten mit herkömmlichen Maskentechniken nicht durchführbar ist.

Der Erfindung liegt die Aufgabe zugrunde ein wirtschaftliches Verfahren zum Aufbringen einer Lötstoppabdeckung auf Leiterplatten zu schaffen, das auch bei dreidimensionalen Leiterplatten anwendbar ist.

Die Lösung dieser Aufgabe erfolgt durch folgende Verfahrensschritte:

a) auf die Leiterplatte wird ganzflächig ein lichtempfindlicher, negativer Lötstopplack aufgebracht;

b) auf den Lötstopplack werden nacheinander ganzflächig eine Metalllschicht und eine metallische Ätzresistschicht aufgebracht;

c) die Ätzresistschicht wird in den unmittelbar an Durchkontaktierungen und/oder Lötpads angrenzenden Bereichen mittels elektromagnetischer Strahlung wieder entfernt;

d) die im Schritt c) freigelegten Bereiche der Metallschicht werden abgetragen;

e) die Ätzresistschicht wird mit Ausnahme der den Durchkontaktierungen und/oder Lötpads entsprechenden Bereiche anodisch kontaktiert;

f) die anodisch kontaktierten Bereiche der Ätzresistschicht werden elektrolytisch abgetragen;

g) die im Schritt f) freigelegte Metallschicht wird abgeätzt;

h) die im Schritt g) freigelegten Bereiche des Lötstopplacks werden belichtet;

i) die verbliebenen Bereiche der Ätzresistschicht und der Metallschicht werden abgeätzt;

j) die im Schritt i) freigelegten unbelichteten Bereiche des Lötstopplacks werden entfernt.

Bei dem erfindungsgemäßen Verfahren wird also durch die Strukturierung von Ätzresistschicht und Metallschicht eine exakte metallische Fotomaske geschaffen, mit deren Hilfe die Fotostrukturierung des Lötstopplackes auch bei dreidimensionalen Leiterplatten auf einfache Weise durchgeführt werden kann. Bei der Strukturierung von Ätzresistschicht und Metallschicht zur Erzeugung dieser Fotomaske wird dabei auf bewährte Techniken zurückgegriffen, die auch bei dreidimensionalen Leiterplatten problemlos durchgeführt werden können. Dabei sind unter diesen Techniken insbesondere die Entfernung der Ätzresistschicht in den unmittelbar an Durchkontaktierungen und/oder Lötpads angrenzenden Bereichen mittels elektromagnetischer Strahlung und das selektive elektrolytische Abtragen der dadurch von den Maskenbereichen abgetrennten Ätzresistschicht hervorzuheben.

Gemäß einer bevorzugten Ausgestaltung des erfindungsgemäßen Verfahrens wird die Metallschicht durch chemische Metallabscheidung auf den Lötstopplack aufgebracht. Dabei hat es sich als besonders günstig erwiesen, wenn als Metallschicht Kupfer abgeschieden wird.

Die Ätzresistschicht wird vorzugsweise durch chemische und/oder galvanische Metallabscheidung aufgebracht. Auch hier kann dann also wieder auf in der Massenfertigung bewährte Techniken zurückgegriffen werden, wobei vorzugsweise als Ätzresistschicht Zinn oder eine Zinn-Blei-Legierung abgeschieden wird und wobei sich Stärken der Ätzresistschicht zwischen einem und zwei Mikrometern als ausreichend erwiesen haben.

Die elektromagnetische Strahlung wird vorzugsweise durch einen Laser erzeugt, da Laserstrahlen für ein Abtragen bzw. Verdampfen der Ätzresistschicht in den erwünschten Bereichen besonders geeignet sind. Die Bewegung des Laserstrahls relativ zur Leiterplatte sollte dann vorzugsweise frei programmierbar sein, d.h. die Umschreibung der Konturen von Durchkontaktierungen und/oder Lötpads kann auf besonders einfache Weise vorgenommen werden. Zur Erzeugung der elektromagnetischen Strahlung hat sich dabei insbesondere ein Nd-YAG-Laser bewährt. Wird dabei die Ätzresistschicht in den unmittelbar an Durchkontaktierungen und/oder Lötpads angrenzenden Bereichen mit einer Bahnbreite zwischen 80 und 100 Mikrometern entfernt, so kann die Strukturierung besonders rasch aber auch mit der nötigen Präzision durchgeführt werden.

Gemäß einer ersten Ausführungsform des erfindungsgemäßen Verfahrens werden die im Schritt c) freigelegten Bereiche der Metallschicht abgeätzt.

Neben diesem wirtschaftlich durchführbaren Ätzvorgang ist es aber auch möglich, die Ätzresistschicht und die Metallschicht in den unmittelbar an Durchkontaktierungen und/oder Lötpads angrenzenden Bereichen mittels elektromagnetischer Strahlung zu entfernen. Die Strukturierung von Ätzresistschicht und Metallschicht kann in diesem Fall dann auf besonders wirtschaftliche Weise in einem einzigen Verfahrensschritt durchgeführt werden.

Die im Schritt g) freigelegten Bereiche des Lötstopplacks können mit besonders geringem Aufwand durch Flutlicht belichtet werden. Als Flutlicht hat sich dabei insbesondere UV-Strahlung bewährt, die eine einwandfreie Belichtung der herkömmlichen fotostrukturierbaren Lötstopplacke ermöglicht.

Die Vorteile des erfindungsgemäßen Verfahrens kommen insbesondere dann zum Tragen, wenn der Lötstopplack auf eine Leiterplatte mit einem dreidimensionalen, spritzgegossenen Substrat und eingespritzten Durchkontaktierungslöchern aufgebracht wird.

Ein Ausführungsbeispiel der Erfindung ist in der Zeichnung dargestellt und wird im folgenden näher beschrieben.

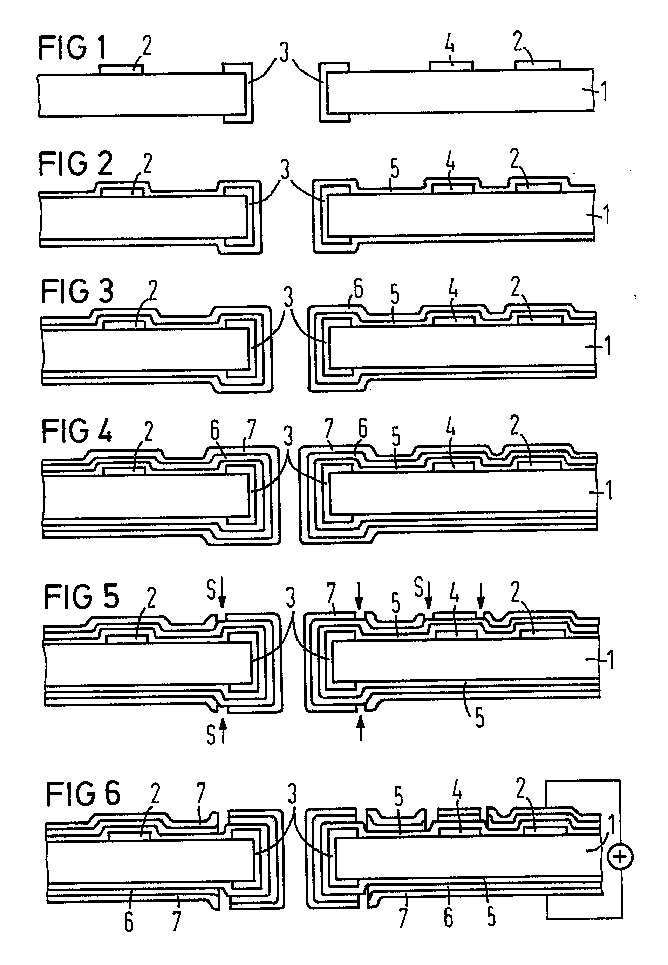

Die Figuren 1 bis 11 zeigen in stark vereinfachter schematischer Darstellung die verschiedenen Verfahrensstadien bei dem Aufbringen einer Lötstoppabdeckung auf Leiterplatten.

Vor der detaillerten Beschreibung ist noch darauf hinzuweisen, daß der Begriff "Leiterplatte" und auch die vereinfachte Zeichnung zunächst auf ein flächiges Gebilde schließen lassen. Die Vorteile des erfindungsgemäßen Verfahrens ohne Fotostrukturierungen mittels der üblichen Maskentechniken beim Aufbringen des Lötstopplacks sind jedoch genau darin zu sehen, daß von der ebenen Form abgewichen werden kann und dreidimensionale Leiterplatten mit beliebigen abgewinkelten oder gekrümmten Formen mit einer Lötstoppabdeckung versehen werden können.

Fig. 1 zeigt einen Schnitt durch einen Teil einer Leiterplatte, auf deren elektrisch isolierendes Substrat 1 als Leiterbild Leiterbahnen 2, Durchkontaktierungen 3 und Lötpads 4 aufgebracht wurden. Bei dem dargestellten Substrat 1 handelt es sich um ein spritzgegossenes Basismaterial mit eingespritzten Löchern für die Durchkontaktierungen 3. Als Material für ein derartiges Substrat 1 ist beispielsweise glasfaserverstärktes Polyetherimid geeignet.

Zum Aufbringen einer Lötstoppabdeckung auf das Leiterbild der in Fig. 1 ausschnittsweise dargestellten Leiterplatte unter Freilassung von Durchkontaktierungen 3 und Lötpads 4 wird nun zunächst gemäß Fig. 2 ganzflächig durch Tauchen oder durch elektrostatisches Spritzen ein lichtempfindlicher Lötstopplack 5 aufgebracht. Bei diesem Lötstopplack 5, der beispielsweise mit einer Stärke zwischen 20 und 30 Mikrometern aufgebracht wird, handelt es sich um einen sogenannten Negativlack, d.h. die belichteten Bereiche werden unlöslich, während die unbelichteten Bereiche beim Entwikkeln entfernt werden. Ein geeigneter Lötstopplack 5 wird beispielsweise von der Fa. Ciba Geigy AG, Basel, CH, unter dem Handelsnamen "PROBIMER 52" vertrieben.

Nach dem Aufbringen des Lötstopplacks 5 wird ganzflächig durch chemische Metallabscheidung gemäß Fig. 3 eine Metallschicht 6 aufgebracht. Auf diese beispielsweise 0,5 μm starke und aus Kupfer bestehende Metallschicht 6 wird anschließend gemäß Fig. 4 ebenfalls ganzflächig eine Ätzresistschicht 7 aufgebracht. Die Stärke dieser beispielsweise aus Zinn bestehenden Ätzresistschicht 7 beträgt ein bis zwei Mikrometer.

Gemäß Fig. 5 wird die Ätzresistschicht 7 dann mit Hilfe eines Nd:YAG-Lasers in einem Scan-Verfahren strukturiert, wobei die Strahlung durch Pfeile S lediglich angedeutet ist. Es ist zu erkennen, daß die Entfernung der Ätzresistschicht 7 auf die unmittelbar an die Durchkontaktierungen 3 und die Lötpads 4 angrenzenden Bereiche begrenzt ist. Die Bahnbreite des Abtrags der Ätzresistschicht 7 mittels der Strahlung S liegt dabei zwischen 80 und 100 Mikrometern.

Nach der geschilderten selektiven Entfernung der Ätzresistschicht 7 werden die hierbei freigelegten Bereiche der Metallschicht 6 durch Ätzen entfernt, wobei hierfür in der Substraktivtechnik übliche Ätzlösungen eingesetzt werden können. Als Alternative zu diesem Ätzen können die entsprechenden Bereiche der Metallschicht 6 aber auch gleichzeitig mit den entsprechenden Bereichen der Ätzresistschicht 7 durch die in Fig. 5 aufgezeigte Strahlung S in einem Schritt abgetragen werden.

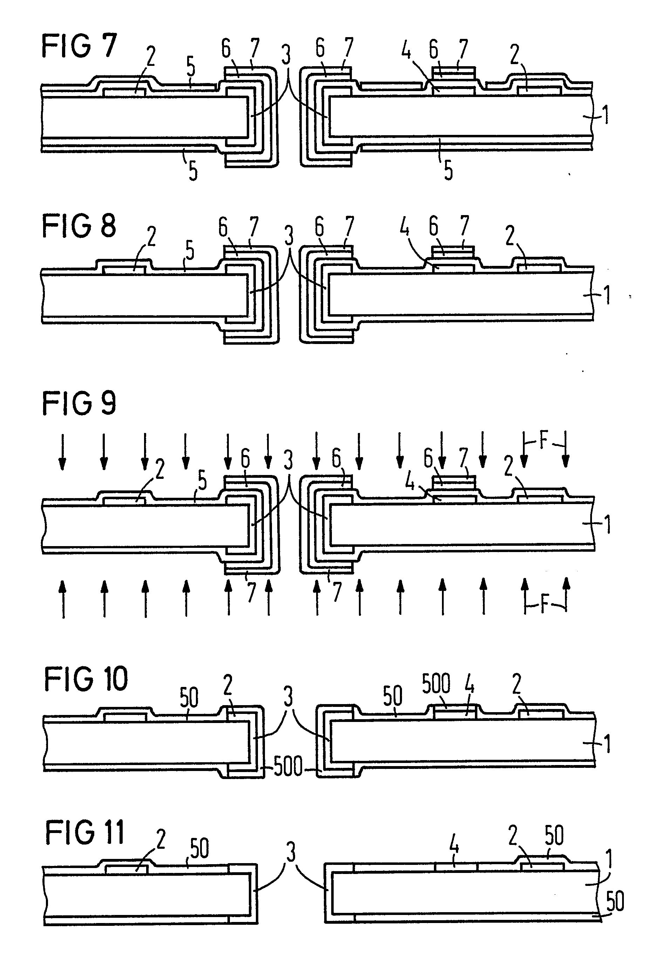

Nach der Entfernung von Ätzresistschicht 7 und Metallschicht 6 in den unmittelbar an Durchkontaktierungen 3 und Lötpads 4 angrenzenden Bereichen werden sämtliche Bereiche der Metallschicht 7 die nicht den Durchkontaktierungen 3 und den Lötpads zugeordnet sind anodisch kontaktiert. Diese anodische Kontaktierung ist in Fig. 6 durch ein Pluszeichen angedeutet. Nach der in Fig. 6 dargestellten anodischen Kontaktierung werden dann gemäß Fig. 7 die derart kontaktierten Bereiche der Ätzresistschicht 7 in einer geeigneten Elektrolytlösung, beispielsweise in einer Bor-Fluorwasserstofflösung, elektrolytisch aufgelöst.

Nach dem geschilderten elektrolylitschen Abtragen der nicht den Durchkontaktierungen 3 und Lötpads 4 zugeordnete Bereiche der Ätzresistschicht 7 werden die dadurch freigelegten Bereiche der Metallschicht 6 abgeätzt, wobei auch hier wieder in der Subtraktivtechnik übliche Ätzlösungen eingesetzt werden können. Gemäß Fig. 8 verbleiben nach diesem Abätzen die Metallschicht 6 und die Ätzresistschicht 7 nur noch in den Bereichen der Durchkontaktierungen 3 und der Lötpads 4.

Gemäß Fig. 9 werden die freigelegten Bereiche des Lötstopplacks 5 durch Flutlicht F belichtet, wobei bei diesem Belichtungsvorgang die verbliebenen Bereiche der Metallschicht 6 und der Ätzresistschicht 7 als Fotomaske wirken und die darunterliegenden Bereiche des Lötstopplacks 5 vor der Belichtung schützen. Als Flutlicht F wird vorzugsweise UV-Strahlung verwendet.

Gemäß Fig. 10 werden anschließend die verbliebenen Bereiche der Ätzresistschicht 7 und der Metallschicht 6 abgeätzt, wobei für das Abätzen der aus Zinn bestehenden Ätzresistschicht 7 beispielsweise Salzsäure geeignet ist. Für das Abätzen der aus Kupfer bestehenden Metallschicht 6 werden wiederum in der Subtraktivtechnik übliche Ätzlösungen eingesetzt. Es ist auch möglich die verbliebenen Bereiche von Ätzresistschicht 7 und Metallschicht 6 zusammen in einer einzigen geeigneten Ätzlö sung zu entfernen. In Fig. 10 sind dabei die belichteten Bereiche des Lötstopplacks 5 mit der Bezugsziffer 50 gekennzeichnet, während die durch die Entfernung von Metallschicht 6 und Ätzresistschicht 7 freigelegten, d.h. unbelichteten Bereiche des Lötstopplacks 5 mit der Bezugsziffer 500 versehen sind.

Nach dem Entfernen der metallischen Fotomaske gemäß Fig. 10 werden die unbelichteten Bereiche 500 des Lötstopplacks 5 durch Eintauchen der gesamten Leiterplatte in eine handelsübliche Entwicklerlösung entwickelt und dadurch vollständig entfernt. Gemäß Fig. 11 verbleiben somit nur noch die belichteten Bereiche 50 des Lötstopplacks 5, welche mit Ausnahme der Durchkontaktierungen 3 und der Lötpads 4 sämtliche Bereiche der Leiterplatte und insbesondere die Leiterbahnen 2 vollständig abdecken. Durch anschließendes Heißverzinnen können dann die Durchkontaktierungen 3 und die Lötpads 4 problemlos selektiv mit Zinn oder auch gegebenenfalls mit einer Zinn-Blei-Legierung überzogen werden.

**Ansprüche**

1. Verfahren zum Aufbringen einer Lötstoppabdeckung auf das Leiterbild von Leiterplatten, insbesondere von dreidimensionalen Leiterplatten, unter Freilassung von Durchkontaktierungen und/oder Lötpads, mit folgenden Verfahrensschritten:

a) auf die Leiterplatte wird ganzflächig ein lichtempfindlicher, negativer Lötstopplack (5) aufgebracht;

b) auf den Lötstopplack (5) werden nacheinander ganzflächig eine Metalllschicht (6) und eine metallische Ätzresistschicht (7) aufgebracht;

c) die Ätzresistschicht (7) wird in den unmittelbar an Durchkontaktierungen (3) und/oder Lötpads (4) angrenzenden Bereichen mittels elektromagnetischer Strahlung (S) wieder entfernt;

d) die im Schritt c) freigelegten Bereiche der Metallschicht (6) werden abgetragen;

e) die Ätzresistschicht (7) wird mit Ausnahme der den Durchkontaktierungen (3) und/oder Lötpads (4) entsprechenden Bereiche anodisch kontaktiert;

f) die anodisch kontaktierten Bereiche der Ätzresistschicht (7) werden elektrolytisch abgetragen;

g) die im Schritt f) freigelegte Metallschicht wird abgeätzt;

h) die im Schritt g) freigelegten Bereiche des Lötstopplacks (5) werden belichtet;

i) die verbliebenen Bereiche der Ätzresistschicht (7) und der Metallschicht (6) werden abgeätzt;

j) die im Schritt i) freigelegten unbelichteten Bereiche (500) des Lötstopplacks (5) werden entfernt.

2. Verfahren nach Anspruch 1,
**dadurch gekennzeichnet,**
daß die Metallschicht (6) durch chemische Metallabscheidung auf den Lötstopplack (5) aufgebracht wird.

3. Verfahren nach Anspruch 2,
**dadurch gekennzeichnet,**
daß als Metallschicht (6) Kupfer abgeschieden wird.

4. Verfahren nach einem der vorhergehenden Ansprüche,
**dadurch gekennzeichnet,**
daß die Ätzresistschicht (7) durch chemische und/oder galvanische Metallabscheidung aufgebracht wird.

5. Verfahren nach Anspruch 4,
**dadurch gekennzeichnet,**
daß als Ätzresistschicht Zinn oder eine Zinn-Blei-Legierung abgeschieden wird.

6. Verfahren nach Anspruch 4 oder 5,
**dadurch gekennzeichnet,**
daß die Ätzresistschicht in einer Stärke zwischen 1 und 2 Mikrometern aufgebracht wird.

7. Verfahren nach einem der vorhergehenden Ansprüche,
**dadurch gekennzeichnet,**
daß die elektromagnetische Strahlung (S) durch einen Laser erzeugt wird.

8. Verfahren nach Anspruch 7,
**dadurch gekennzeichnet,**
daß die Bewegung des Laserstrahls relativ zur Leiterplatte frei programmierbar ist.

9. Verfahren nach Anspruch 7 oder 8,
**dadurch gekennzeichnet,**
daß zur Erzeugung der elektromagnetischen Strahlung ein Nd:YAG-Laser verwendet wird.

10. Verfahren nach einem der Ansprüche 7 bis 9,
**dadurch gekennzeichnet,**
daß die Ätzresistschicht (7) in den unmittelbar an Durchkontaktierungen (3) und/oder Lötpads (4) angrenzenden Bereichen mit einer Bahnbreite zwischen 80 und 100 Mikrome tern entfernt wird.

11. Verfahren nach einem der vorhergehenden Ansprüche,
**dadurch gekennzeichnet,**
daß die im Schritt c) freigelegten Bereiche der Metallschicht (6) abgeätzt werden.

12. Verfahren nach einem der Ansprüche 1 bis 10,
**dadurch gekennzeichnet,**
daß die Ätzresistschicht (7) und die Metallschicht (6) in den unmittelbar an Durchkontaktierungen (3) und/oder Lötpads (4) angrenzenden Bereichen mittels elektromagnetischer Strahlung (S) entfernt werden.

13. Verfahren nach einem der vorhergehenden Ansprüche,
**dadurch gekennzeichnet,**
daß die im Schritt g) freigelegten Bereiche des Lötstopplacks (5) durch Flutlicht (F) belichtet werden.

14. Verfahren nach Anspruch 13,
daß als Flutlicht (F) UV-Strahlung verwendet wird.

15. Verfahren nach einem der vorhergehenden Ansprüche,
**dadurch gekennzeichnet,**
daß der Lötstopplack (5) auf eine Leiterplatte mit einem dreidimensionalen, spritzgegossenen Substrat (1) und eingespritzten Durchkontaktierungslöchern aufgebracht wird.

FIG 1

FIG 2

FIG 3

FIG 4

FIG 5

FIG 6

FIG 7

FIG 8

FIG 9

FIG 10

FIG 11